**Europäisches Patentamt**

**European Patent Office**

**Office européen des brevets**

(19)

(11) Veröffentlichungsnummer : **0 526 730 B1**

(12)

# EUROPÄISCHE PATENTSCHRIFT

(45) Veröffentlichungstag der Patentschrift :
01.03.95 Patentblatt 95/09

(51) Int. Cl.$^6$ : **G01D 5/249, H03M 1/00**

(21) Anmeldenummer : **92110883.3**

(22) Anmeldetag : **26.06.92**

(54) **Längen- oder Winkelmesseinrichtung.**

(30) Priorität : **03.08.91 DE 4125865**
**18.04.92 DE 4212952**

(43) Veröffentlichungstag der Anmeldung :
**10.02.93 Patentblatt 93/06**

(45) Bekanntmachung des Hinweises auf die
Patenterteilung :
**01.03.95 Patentblatt 95/09**

(84) Benannte Vertragsstaaten :
**DE FR GB IT**

(56) Entgegenhaltungen :
**EP-A- 0 318 597**
**US-A- 5 012 238**

(73) Patentinhaber : **Dr. Johannes Heidenhain**
**GmbH**
**Postfach 12 60**
**D-83292 Traunreut (DE)**

(72) Erfinder : **Nelle, Günther, Dr.**
**Eichenweg 12**
**W-8221 Bergen (DE)**

## Beschreibung

Es wird aüsgegangen vor Längen- oder Winkelmeßeinrichtungen gemäß den Oberbegriffen der Ansprüche 1, 2 und 8.

Derartige Meßeinrichtungen werden insbesondere bei Bearbeitungsmaschinen zur Messung der Relativlage eines Werkzeugs bezüglich eines zu bearbeitenden Werkstücks sowie bei Koordinatenmeßmaschinen zur Ermittlung von Lage und/oder Abmessungen von Prüfobjekten eingesetzt.

Bei solchen Meßeinrichtungen unterscheidet man zwischen inkrementalen Längen- oder Winkelmeßeinrichtungen und codierten Längen- oder Winkelmeßeinrichtungen.

Eine inkrementale Wegmeßeinrichtung weist einen Teilungsträger mit einer inkrementalen Teilung auf, die von einer Abtasteinrichtung zur Erzeugung von periodischen Abtastsignalen abgetastet wird, aus denen in einer Auswerteeinrichtung Zählimpulse für jedes Teilungsinkrement gewonnen werden. Die Zählung dieser Zählimpulse durch einen Zähler liefert den momentanen Positionsmeßwert und erfolgt jeweils von frei wählbaren Meßbezugslagen dieser inkrementalen Teilung ausgehend; diesen Meßbezugslagen können zur gegenseitigen Unterscheidung codierte Referenzmarken absolut zugeordnet sein, deren Lage einer bestimmten Position absolut zugeordnet sind.

Die an den Referenzmarken erzeugten Referenzimpulse können auf verschiedene Weise verwertet werden, z.B. zum Reproduzieren der Nullbezugslage im Zähler, zum Anfahren einer bestimmten Nullbezugslage zu Beginn einer Messung oder zur Kontrolle der Zählergebnisse des Zählers sowie zur Auswertung in einer nachgeschalteten numerischen Steuerung.

Aus der DE-AS 12 58 120 ist eine Längenmeßeinrichtung bekannt, bei der zwei stetige Strichfolgen unterschiedlicher Intervallänge auf einer Nivellierlatte vorgesehen sind. In einem Teilungsbereich, welcher der Länge des kleinsten gemeinsamen Vielfachen der Intervallängen der beiden Strichfolgen entspricht, werden die Restintervalle zwischen dem Index der Ablesevorrichtung und den diesem in steigendem oder fallendem Teilungssinn nächstliegenden Teilstrichen der Strichfolgen nacheinander mikrometrisch gemessen und aus den so erhaltenen Mikrometerablesungen die Lage des Index der Ablesevorrichtung in bezug auf den Teilungsnullpunkt berechnet.

Die EP-A- 0 318 597 beschreibt einen Absolut-Positionskodierer, bei dem die absolute Position eines sich verschiebenden Glieds dadurch erfaßt wird, daß interpolierte Daten, die von Adressendaten des niedrigsten Kanals der größten Anzahl von Zyklen gelesen werden, kombiniert werden mit den korrigierten Daten der Kanäle, die höher als der niedrigste ausgelesene Kanal sind, basierend auf den besagten Adressendaten der Korrektur.

Die US-A- 5 012 238 gibt einen Absolutkodierer an, bei dem durch Gebrauch eines Paares von "Pitch"-Signalen, die Perioden ohne gemeinsamen Faktor haben, ein hoher Auflösungsgrad erhalten wird, ohne daß die Anzahl der Pitch-Signalspuren bedeutend erhöht werden muß.

Eine weitere Positionsmeßeinrichtung ist aus der WO 89/11080-A1 bekannt. Dort wird folgendes beschrieben:

Um in einer Positionsmeßeinrichtung praktisch jederzeit ein lagecodiertes Signal zu erzeugen, werden zwei Spuren mittels zweier Sensoren abgetastet, die je ein sinusförmiges Signalpaar (cos $\alpha$; sin $\alpha$; cos $\beta$, sin $\beta$) oder ein ähnliches periodisches Signal mit einer jederzeit definierten Phasenlage erzeugen, deren Periodenlängen sich wie n/n+1 verhalten. Der gesuchte Relativabstand ergibt sich dann als Differenz der beiden Phasenlagen.

Diesen Stand der Technik gegenüber liegt die Aufgabe zugrunde, eine Meßeinrichtung zur absoluten Positionsbestimmung zu schaffen, die inkrementale Ausgangssignale von einer möglichst geringen Anzahl von Spuren liefert, wobei eine hohe Auflösung, ein geringer Einfluß von Interpolationsfehlern und große Meßlängen gefordert sind.

Diese Aufgabe wird mit Längen- oder Winkelmeßeinrichtungen gelöst, die die Merkmale der unabhängigen Ansprüche 1, 2 oder 8 aufweisen.

Die Vorteile der erfindungsgemäßen Meßeinrichtungen liegen darin, daß mit wenigen Inkrementalspuren eine absolutcodierte Position bei großer Meßlänge und mit hoher Auflösung bestimmt werden kann, wobei jede Inkrementalspur interpolationsgeeignet ist.

Mit Hilfe von Ausführungsbeispielen werden die Meßeinrichtungen anhand der Schema-Zeichnungen näher erläutert:

Es zeigt

Figur 1    die Kernmerkmale einer Längenmeßeinrichtung;
Figur 2    eine Maßverkörperung;
Figur 3    eine weitere Maßverkörperung und
Figur 4    eine Maßverkörperung mit einer Referenzspur.

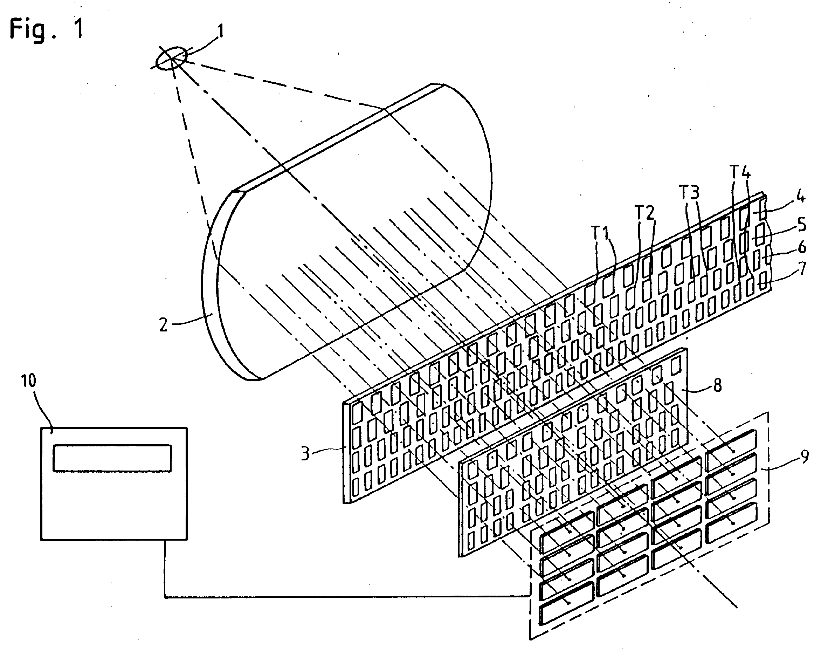

Eine in Figur 1 dargestellte Längenmeßeinrichtung weist eine Beleuchtungsquelle 1 und einen Kondensor 2 auf, die paralleles Licht auf eine Maßverkörperung 3 richten. Die Maßverkörperung 3 weist vier Spuren mit Meßteilungen 4, 5, 6 und 7 auf, deren Teilungsperioden sich voneinander unterscheiden.

Des weiteren ist eine Abtastplatte 8 und eine Detektoreinheit 9 vorgesehen, deren Abtast- und Detektorfelder den Meßteilungen angepaßt und zugeordnet sind. Eine Auswerteeinrichtung trägt das Bezugszeichen 10.

Jede Spur der Meßteilungen 4, 5, 6 und 7 wird in bekannter Weise mit vier um 1/4 Teilungsperiode zueinander versetzten Abtastfeldern abgetastet. Dadurch werden in bekannter Weise je Spur aus jeder Meßteilung 4, 5, 6 und 7 zwei um 1/4 Teilungsperiode zueinander versetzte sinusförmige Signale erzeugt, die in vorbestimmbaren Schritten interpolationsfähig sind.

Die Abstufung der Teilungsperioden zueinander ermöglicht eine besonders einfache und zuverlässige Auscodierung des zu ermittelnden absoluten Positionswertes. Die mathematischen Zusammenhänge der Teilungsabstufungen ergeben sich daraus, daß eine erste Meßteilung 4 eine Teilungsperiode $T_1$ mit dem Wert P aufweist und die Kehrwerte der Teilungsperioden $T_N$ der weiteren Meßteilungen 5,6,7 abzüglich des Kehrwertes 1/P der Teilungsperiode $T_1$ der ersten Meßteilung 4 eine endliche geometrische Reihe bis zum (n-1)-ten Glied für die n-te Meßteilung darstellen.

Als Formel ausgedrückt:

für die erste Spur $\frac{1}{T_1} = \frac{1}{P} \rightarrow T_1 = P$

für die zweite Spur $\frac{1}{T_2} - \frac{1}{P} = \frac{1}{P*A} \rightarrow T_2 = \frac{P*A}{1+A}$

für die dritte Spur $\frac{1}{T_3} - \frac{1}{P} = \frac{1}{P*A} + \frac{1}{P*A^2} \rightarrow T_3 = \frac{P*A^2}{1+A+A^2}$

Da das Prinzip sowohl bei steigender Teilungsperiode als auch bei fallender Teilungsperiode gilt, können zwei allgemein gültige Formeln aufgestellt werden, nach denen die Teilungsperioden der Meßteilungen variieren:

$$(1) \quad T_{(N)} = P * \frac{A^{(N-1)}}{\sum_{i=0}^{N-1}(A^i)} \qquad \text{für positive Vorzeichen der einzelnen Glieder oder}$$

$$(2) \quad T_{(N)} = P * \frac{A^{(N-1)}}{A^{(N-1)} - \sum_{i=0}^{N-2}(A^i)} \qquad \text{für negative Vorzeichen der einzelnen Glieder}$$

Dabei bedeuten die Größen:

P = Teilungsperiode der Grund-Meßteilung (1. Spur)
$T_N$ = Teilungsperiode der weiteren Meßteilungen (N. Spur)
B = Interpolationsfaktor
A = Anzahl der Codewerte innerhalb einer Teilungsperiode ab der 2. Spur der Meßteilungen (A≦B/2)
$Z_N$ = Interpolationswert der N. Spur.

Aus der gemeinsamen Auswertung der Spuren ergibt sich der absolut codierte Positionswert CP näherungsweise nach folgender Formel (3):

$$CP = \frac{P}{B} * x_1 \genfrac(){}{0}{}{+}{-} P*\text{integer}\left(\frac{A}{B} * x_2\right) \genfrac(){}{0}{}{+}{-} P*A*\text{integer}\left(\frac{A}{B} * x_3\right)$$

$$\genfrac(){}{0}{}{+}{-} P*A^2*\text{integer}\left(\frac{A}{B} * x_4\right) \genfrac(){}{0}{}{+}{-} \ldots$$

$$\genfrac(){}{0}{}{+}{-} P*A^{(N-2)}* \text{integer}\left(\frac{A}{B} * x_N\right)$$

darin bedeuten:

$$x_1 = Z_1$$

$$x_2 = \left(2B + Z_2 - Z_1 - \frac{x_1}{A} + \frac{B}{2A}\right) \quad \mathrm{mod}\ B$$

$$x_3 = \left(2B + Z_3 - Z_2 - \frac{x_2}{A} + \frac{B}{2A}\right) \quad \mathrm{mod}\ B$$

$$\vdots$$

$$x_N = \left(2B + Z_N - Z_{N-1} - \frac{x_{N-1}}{A} + \frac{B}{2A}\right) \mathrm{mod}\ B$$

in der "modulo"-Berechnungsweise bedeutet:
$V \bmod W = V - W * \text{integer}(V/W)$
$P =$ Grundteilung (Teilungsperiode der 1.Spur)
$T_N =$ Teilungsperiode der N.Spur
$B =$ Interpolationsfaktor (B Schritte innerhalb einer Teilungsperiode)
$A =$ Anzahl der Codewerte innerhalb einer Teilungsperiode ab der 2.Spur ($A \leq B/2$)
$Z_N =$ Interpolationswert der Spur N (Verschiebungs-Bruchteil)
    Dabei gilt das positive (+) Vorzeichen der einzelnen Glieder für Formel (1) und das negative (-) Vorzeichen für Formel (2).
    Eine weitere Möglichkeit der Abstufung der Meßteilungen hinsichtlich ihrer Teilungsperioden besteht in der Abstufung nach den Regeln einer geometrischen Folge, was sich dadurch ausdrückt, daß eine erste Meßteilung 4 eine Teilungsperiode $T_1$ mit dem Wert P aufweist und die Kehrwerte der Teilungsperioden $T_N$ der weiteren Meßteilungen 5, 6, 7 abzüglich des Kehrwertes $1/P$ der Teilungsperiode $T_1$ der ersten Meßteilung 4 nach einer geometrischen Folge gestuft sind.
    Diese Variante wird in Formeln für die positiven Vorzeichen der Glieder bzw. die negativen Vorzeichen der Glieder wie folgt ausgedrückt:

für die erst Spur $\frac{1}{T_1} = \frac{1}{P} \rightarrow T_1 = P$

für die zweite Spur $\frac{1}{T_2} - \frac{1}{T_1} = \frac{1}{P*A} \rightarrow T_2 = \frac{P*A}{A+1}$

für die dritte Spur $\frac{1}{T_3} - \frac{1}{T_1} = \frac{1}{P*A^2} \rightarrow T_3 = \frac{P*A^2}{A^2+1}$

Daraus ergibt sich allgemein für die Abstufung der Teilungsperioden:

(4)      $T_N = P * \dfrac{A^{(N-1)}}{A^{(N-1)}+1}$ für positive Vorzeichen der einzelnen Glieder oder

(5)      $T_N = P \dfrac{A^{(N-1)}}{A^{(N-1)}-1}$ für negative Vorzeichen der einzelnen Glieder,

unter Beibehaltung der Bedeutung der einzelnen Größen, die bereits erläutert wurden.
    Zur Ermittlung des absolut codierten Positionswertes gilt dieselbe Formel (3) für CP mit positivem (+) Vorzeichen für (4) und mit negativem (-) Vorzeichen für (5), jedoch bedeuten:

$$x_1 = Z_1$$

$$x_2 = \left(2B + Z_2 - Z_1 - \frac{x_1}{A} + \frac{B}{2A}\right) \mathrm{mod}\ B$$

$$x_3 = \left(2B + Z_3 - Z_1 - \frac{x_2}{A} + \frac{B}{2A}\right) \bmod B$$
$$\vdots$$
$$x_N = \left(2B + Z_N - Z_1 - \frac{x_{N-1}}{A} + \frac{B}{2A}\right) \bmod B$$

Für die vier erwähnten Teilungsmöglichkeiten nach (1), (2), (4) und (5) gilt:

Bei N Spuren ist der Bereich der absoluten Codierung $A^{(N-1)} * B$ Meßschritte. Die zulässige Phasenabweichung von Spur zu Spur (bei (1) und (2)) bzw. von der 1. zur N. Spur (bei (4) und (5)) beträgt $\pm \frac{B}{2A}$ und zwar aus folgendem Grund:

Um bei Code-Meßsystemen mit mehreren Inkrementalspuren unterschiedlicher Teilung Meßfehler zu vermeiden, die bei geringfügiger Verlagerung der Spuren zueinander infolge notwendiger Toleranzen entstehen können, sollten die Ausgangssignale aller Spuren zunächst mit den bekannten Verfahren B-fach unterteilt werden, so daß der Meßschritt für die Grundteilung 1/B der Teilungsperiode P der Grundteilung beträgt. Für die Grundteilung ist die Anzahl der Codewerte innerhalb einer Teilungsperiode gleich B. Für alle weiteren Spuren sind aber aus B Interpolationsschritten nur A Codewerte zu bilden, wobei $A \leqq B/2$ (speziell A=B/8 oder A=B/16) ist. Dadurch ist ein fehlerfreier codierter Positionswert CP auch noch gegeben, wenn sich die Phasenlage der einzelnen Teilungsspuren zueinander um bis zu $\pm 1/2 * B/A$ verändert.

Beispiel

N = 4 Spuren
B = 100fach Interpolation
A = 10 Codewerte ab der 2. Spur
P = 100μm Teilungsperiode der 1. Spur (Grundteilung)
$T_N$ = Teilungsperioden der N Spuren nach
Gleichung (1)

$$T_N = P * \frac{A^{(N-1)}}{\sum\limits_{i=0}^{N-1}(A^i)}$$

$T_1$ = 100μm
$T_2$ = 90,9090909μm
$T_3$ = 90,09009009μm
$T_4$ = 90,00900090009μm
zul. Phasenfehler von Spur zu Spur

$$< \pm\frac{B}{2A} = \pm\frac{1}{2} * \frac{100}{10} = \pm 5 \text{ Interpolationsschritte}$$
$$< \pm 5 \ \mu m$$

Aus den Anzeigen $Z_1$, $Z_2$, $Z_3$ und $Z_4$ der Verschiebungsbruchteile je Spur bei einer bestimmten Position CP berechnet sich der Positionswert CP aus:

$$CP = \frac{P}{B} * x_1 + P * \text{integer}\left(\frac{A}{B} x_2\right) + P*A*\text{integer}\left(\frac{A}{B} x_3\right) + P*A^2*\text{integer}\left(\frac{A}{B} x_4\right),$$

wobei

$$x_1 = Z_1$$

$$x_2 = \left(2B + Z_2 - Z_1 - \frac{x_1}{A} + \frac{B}{2A}\right) \bmod B$$

$$x_3 = \left(2B + Z_3 - Z_2 - \frac{x_2}{A} + \frac{B}{2A}\right) \bmod B$$

$$x_4 = \left(2B + Z_4 - Z_3 - \frac{x_3}{A} + \frac{B}{2A}\right) \bmod B$$

Bei fehlerfreier Phasenlage der Spuren zueinander ergibt sich aus den vier Anzeigen $Z_1=38$, $Z_2=12$, $Z_3=39$, $Z_4=52$ mit in die Formel (3) eingesetzten Zahlenwerten folgender codierter Positionswert CP:

$$x_1 = 38$$

$$x_2 = \left(2*100 + 12 - 38 - \frac{38}{10} + \frac{100}{2*10}\right) \bmod 100 = 175 \ \bmod 100 = 75$$

$$x_3 = \left(2*100 + 39 - 12 - \frac{75}{10} + \frac{100}{2*10}\right) \bmod 100 = 225 \ \bmod 100 = 25$$

$$x4 = \left(2*100 + 52 - 39 - \frac{25}{10} + \frac{100}{2*10}\right) \bmod 100 = 216 \ \bmod 100 = 16$$

$$CP = \frac{100}{100}*38 + 100*\text{integer}\left(\frac{10}{100}*75\right) + 100*10*\text{integer}\left(\frac{10}{100}*25\right)$$

$$+ 100*10^2*\text{integer}\left(\frac{10}{100}*16\right)$$

$$= 38 + 700 + 2000 + 10000 = 12738$$

CP=12738

Ein Phasenversatz der Spur 3 und 4 $\mu$m führt zu $Z_3=43$ und

$$x_3 = \left(2*100 + 43 - 12 - \frac{75}{10} + \frac{100}{2*10}\right) \bmod 100 = 229 \ \bmod 100 = 29$$

$$x_4 = \left(2*100 + 52 - 43 - \frac{29}{10} + \frac{100}{2*10}\right) \bmod 100 = 212 \ \bmod 100 = 12$$

$$CP_f = \frac{100}{100}*38 + 100*\text{integer}\left(\frac{10}{100}*75\right) + 100*10*\text{integer}\left(\frac{10}{100}*29\right)$$

$$+ 100*10^2*\text{integer}\left(\frac{10}{100}*12\right)$$

$$= 38 + 700 + 2000 + 10000 = 12738$$

CP$_f$=12738=CP

Ein Phasenversatz der Spur 3 um 4 $\mu$m liefert also keine fehlerhafte Anzeige!

Wird im obigen Beispiel abweichend von der Bedingung A≦B/2 hingegen A=B=100 gewählt, ergibt sich zwar ein größerer Meßbereich $A^{(N-1)}*B$, doch sind keine Toleranzen für die Spurlagen möglich.

Bei fehlerfreier Phasenlage der Spuren ergibt sich aus vier Anzeigen von Verschiebungsbruchteilen: $Z_1=36$, $Z_2=46$, $Z_3=94$, $Z_4=21$ folgender codierter Positionswert CP gemäß Formel (3):

$$x_1 = 36$$

$$x_2 \left(2*100+46-36-\frac{36}{100}+\frac{100}{2*100}\right) \mathrm{mod}\,100 = 210 \;\mathrm{mod}\,100 = 10$$

$$x_3 = \left(2*100+94-46-\frac{10}{100}+\frac{100}{2*100}\right) \mathrm{mod}\,100 = 248 \;\mathrm{mod}\,100 = 48$$

$$x_4 = \left(2*100+21-94-\frac{48}{100}+\frac{100}{2*100}\right) \mathrm{mod}\,100 = 127 \;\mathrm{mod}\,100 = 27$$

$$CP = \frac{100}{100}*36+100*\mathrm{integer}\left(\frac{100}{100}*10\right)+100*100*\mathrm{integer}\left(\frac{100}{100}*48\right)$$

$$+100*100^2*\mathrm{integer}\left(\frac{100}{100}*27\right)$$

$$=36+1000+480000+27000000=27481036$$

Bei einem Phasenversatz der Spur 3 um nur 1μm ergibt sich

$$x_3 = \left(2*100+95-46-\frac{10}{100}+\frac{100}{2*100}\right) \mathrm{mod}\,100 = 249 \;\mathrm{mod}\,100 = 49$$

$$x_4 = \left(2*100+21-95-\frac{49}{100}+\frac{100}{2*100}\right) \mathrm{mod}\,100 = 126 \;\mathrm{mod}\,100 = 26$$

$$CP_f = \frac{100}{100}*36+100*\mathrm{integer}\left(\frac{100}{100}*10\right)+100*100*\mathrm{integer}\left(\frac{100}{100}*49\right)$$

$$+100*100^2*\mathrm{integer}\left(\frac{100}{100}*26\right)$$

$$=36+1000+490000+26000000=26491036$$

$CP_f \neq CP$!

Ein Phasenversatz der Spur 3 um 1μm führt in diesem Beispiel zu einer fehlerhaften Anzeige von etwa 1m!!

Die einzelnen Interpolationswerte $Z_N$ in den jeweiligen Spuren lassen sich mit Hilfe des absolutcodierten Positionswertes CP ermitteln.

Für N Spuren ergeben sich nach (1)

$$T_N = P*\frac{A^{(N-1)}}{\sum\limits_{i=0}^{N-1}(A^i)}$$

bei einem Positionswert CP< $A^{(N-1)}*B$ (Meßbereich) die Interpolationswerte $Z_N$ der einzelnen Spuren N zu:

$Z_N = \mathrm{round}\,(\frac{B}{T_N}\,[CP \bmod T_N])$.

Die einzelnen Interpolationswerte $Z_N$ nehmen innerhalb jeder Periode $T_N$ die Werte von 0 bis B-1 an, da

7

eine Periode $T_N$ in B gleiche Teile aufgeteilt wird.

Beispiel:

N = 4 Spuren
B = 100 fach Interpolation,
A = 10 Codewerte innerhalb einer Teilungsperiode ab der 2.Spur,
P = 100μm Teilungsperiode der 1.Spur.
   Nach Formel (1) wird:

$$T_1 = 100$$

$$T_2 = 100 * \frac{10}{1+10} = 100 * \frac{10}{11} = 90,9090909...$$

$$T_3 = 100 * \frac{100}{1+10+100} = 100 * \frac{100}{111} = 90,09009009...$$

$$T_4 = 100 * \frac{1000}{1+10+100+1000} = 100 * \frac{1000}{1111} = 90,00900090009...$$

Der Meßbereich ist: $A^{(N-1)}*B = 10^3*100 = 100000$ Meßschritte, wobei 1 Meßschritt $= \frac{P}{B} = \frac{100\mu m}{100} = 1\mu m$ beträgt.

Für eine Position von z.B. CP=12738μm ergeben sich für die einzelnen Spuren folgende Interpolationswerte:

$$Z_1 = \text{round}\left(\frac{B}{T_1} \quad [CP \bmod T_1]\right) = \text{round}\left(\frac{100}{100} [12738 \bmod 100]\right) = \underline{38}$$

$$Z_2 = \text{round}\left(\frac{100}{T_2} \quad [12738 \bmod 90,90909]\right) \qquad\qquad \underline{=12}$$

$$Z_3 = \text{round}\left(\frac{100}{T_3} \quad [12738 \bmod 90,09009]\right) \qquad\qquad \underline{=39}$$

$$Z_4 = \text{round}\left(\frac{100}{T_4} \quad [12738 \bmod 90,0090009]\right) \qquad\qquad \underline{=52}$$

Die einzelnen Interpolationswerte $Z_N$ lassen sich als Verschiebungsbruchteile anzeigen.

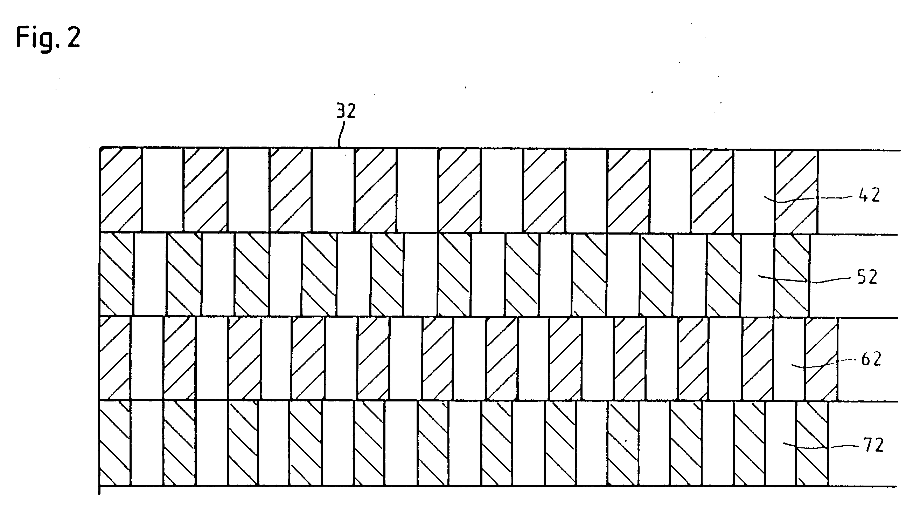

Figur 2 zeigt eine Maßverkörperung 32, deren Meßteilungen 42, 52, 62 und 72 nach einem der vorstehenden Schemata abgestuft sind. Aus zeichnerischen Gründen ist das Prinzip allerdings stark übertrieben dargestellt worden.

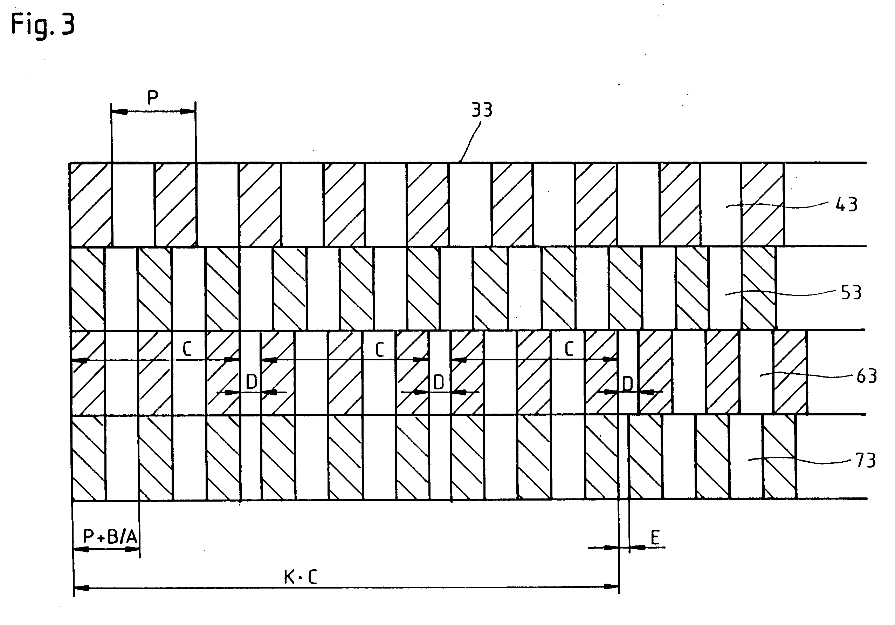

Figur 3 zeigt eine Besonderheit der Erfindung, denn es müssen die Abstufungen nicht - wie bisher beschrieben - kontinuierlich erfolgen, sondern es können Sprungstellen in den Meßteilungen 63 und 73 vorgesehen sein.

Das heißt, die Teilungsperioden der Meßteilungen 63, 73 und 83 sind jeweils untereinander gleich, aber nach einer vorbestimmbaren Anzahl von Teilungsperioden erfolgt ein Phasenversatz, so daß die Abschnittsgrenzen einer Anzahl von Teilungsperioden je Spur insgesamt variieren.

Im Beispiel sind vier Spuren gezeigt, wobei die Spuren folgenden Aufbau aufweisen:

Spur 43 (1.Spur): durchgehende Teilungsperiode P;

Spur 53 (2 Spur): durchgehende Teilungsperiode P+B/A;

Spur 63 (3.Spur): C Abschnitte, mit einer Teilungsperiode P+B/A und jeweils nach einem Abschnitt an den Abschnittsgrenzen einen geeigneten Phasenversatz von D;

Spur 73 (4.Spur): C Abschnitte, mit einer Teilungsperiode P+B/A und jeweils nach K*C Abschnitten an den Abschnittsgrenzen einen anderen zusätzlichen Phasenversatz E, so daß an diesen Abschnittsgrenzen der Soll-Phasenversatz wieder gegeben ist.

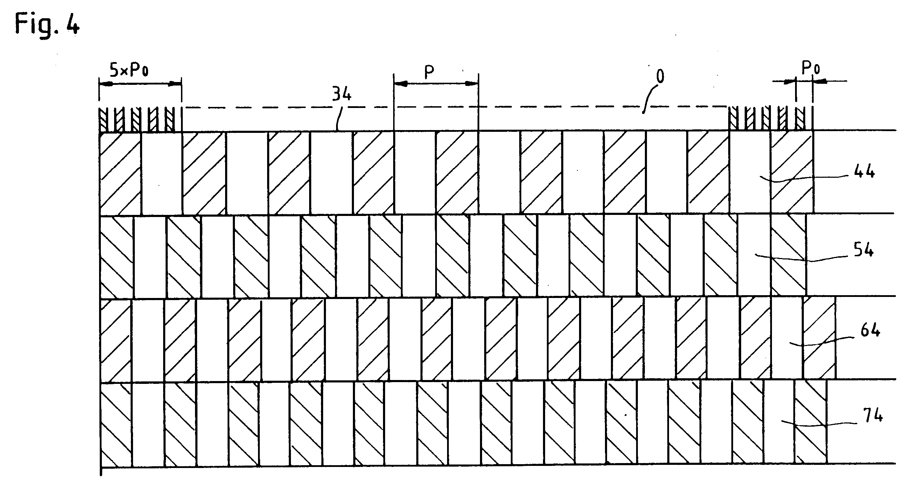

Figur 4 zeigt eine Maßverkörperung 34, deren Meßteilungen 44, 54, 64 und 74 nach einem der vorstehenden Schemata abgestuft sind. Eine Spur 0 ist als Referenzspur vorgesehen, auf die die Phasenlage der nachgeordneten Spuren 44 bis 74 bezogen ist. Aus zeichnerischen Gründen ist das Prinzip allerdings stark übertrieben dargestellt worden.

Zum Ermitteln eines Codewertes aus N Spuren müssen zwischen den Inkrementen der Spuren Interpolationswerte gebildet werden. Interpolationsfehler beeinflussen direkt den Wert des Phasenwinkels zwischen den Spuren. Sie sind umso größer, je gröber die Teilungsperiode ist. Um die Interpolationsfehler klein zu halten, wird zusätzlich zu den nach Gleichung (1) berechneten N Spuren eine weitere Spur 0 mit einer Teilungsperiode $P_o$, die kleiner als die Teilungsperiode P der Grundspur 44 ist,

$$\text{(vorzugsweise } P_o = \frac{1}{A} \cdot P = \frac{1}{10} P; \text{ aus zeichentechnischen Gründen sind } \frac{1}{5}P \text{ dargestellt)}$$

vorgesehen und die Phasenlagen der N Spuren auf diese Spur 0 bezogen. Dadurch verringert sich der Einfluß der Interpolationsfehler.

Weiter werden in einer Auswerteeinheit 10 Mittel vorgesehen, mit deren Hilfe laufend der Phasenfehler zwischen den N Spuren und der Grundspur 44 bzw. der Referenzspur 0 bestimmt wird und beim Überschreiten eines maximalen Wertes von z.B. $\pm 0{,}4P_o$ zum Schalten einer Fehleranzeige benutzt wird. Zum Ermitteln des Phasenfehlers wird zunächst aus den Ist-Interpolationswerten der einzelnen Spuren der Codewert bestimmt, dann aus dem Codewert die Soll-Interpolationswerte berechnet und aus der Differenz zwischen Soll- und Istwerten der Phasenfehler.

Da die erfindungsgemäße Längen- oder Winkelmeßeinrichtung ausschließlich Meßteilungen mit Gitterstruktur - also Inkrementalteilungen - aufweist, kann die Meßeinrichtung auch als rein inkrementale Wegmeßeinrichtung arbeiten.

Die Erfindung ist nicht auf das beschriebene optoelektronische Meßprinzip beschränkt. Auch die anderen bekannten physikalischen Meßprinzipien - wie magnetische, induktive und kapazitive Abtastungen - sind bei entsprechender Ausgestaltung von Meßteilungen und Abtasteinrichtungen möglich und stellen glatte Äquivalente dar.

**Patentansprüche**

1. Längen- oder Winkelmeßeinrichtung mit einer Maßverkörperung die mehrere Meßteilungen mit unterschiedlichen Teilungsperioden aufweist, denen jeweils Abtasteinrichtungen zugeordnet sind, dadurch gekennzeichnet, daß eine erste Meßteilung (4) eine Teilungsperiode ($T_1$) mit dem Wert P aufweist und die Kehrwerte der Teilungsperioden ($T_N$) der weiteren Meßteilungen (5, 6, 7) abzüglich des Kehrwertes 1/P der Teilungsperiode ($T_1$) der ersten Meßteilung (4) eine endliche geometrische Reihe bis zum (n-1)-ten Glied für die N-te Meßteilung ($T_N$) darstellen.

2. Längen- oder Winkelmeßeinrichtung mit einer Maßverkörperung die mehrere Meßteilungen mit unterschiedlichen Teilungsperioden aufweist, denen jeweils Abtasteinrichtungen zugeordnet sind, dadurch gekennzeichnet, daß eine erste Meßteilung (4) eine Teilungsperiode ($T_1$) mit dem Wert P aufweist und die Kehrwerte der Teilungsperioden ($T_N$) der weiteren Meßteilungen (5, 6, 7) abzüglich des Kehrwertes 1/P der Teilungsperiode ($T_1$) der ersten Meßteilung (4) nach einer geometrischen Folge gestuft sind.

3. Längen- oder Winkelmeßeinrichtung nach den Ansprüchen 1 oder 2, dadurch gekennzeichnet, daß die Abstufung der Teilungsperioden ($T_N$) kontinuierlich verläuft.

4. Längen- oder Winkelmeßeinrichtung nach den Ansprüchen 1 oder 2, dadurch gekennzeichnet, daß die Abstufung der Teilungsperioden ($T_N$) durch unterschiedlich lange Blöcke (C, K∗C) mit jeweils gleicher Teilungsperiode P+B/A erfolgt und daß die Blöcke (C, K∗C) zueinander eine Phasenverschiebung (D bzw. E) aufweisen.

5. Längen- oder Winkelmeßeinrichtung nach Anspruch 4, dadurch gekennzeichnet, daß die Phasenverschiebung (D bzw. E) in den Spuren der Meßteilungen (63, 73) unterschiedlich ist.

6. Längen- oder Winkelmeßeinrichtung nach Anspruch 1, dadurch gekennzeichnet, daß die Abstufung der Meßteilungen (4, 5, 6, 7; 42, 52, 62, 72; 43, 53, 63, 73) bei positivem Vorzeichen der einzelnen Glieder nach der Formel (1)

EP 0 526 730 B1

$$(1) \quad T_N = P * \frac{A^{(N-1)}}{\sum\limits_{i=0}^{N-1}(A^i)}$$

und bei negativem Vorzeichen der einzelnen Glieder nach der Formel

$$(2) \quad T_N = P * \frac{A^{(N-1)}}{A^{(N-1)}} - \sum\limits_{i=0}^{N-2}(A^i)$$

erfolgt.

7. Längen- oder Winkelmeßeinrichtung nach Anspruch 2, dadurch gekennzeichnet, daß die Abstufung der Meßteilungen bei positivem Vorzeichen der einzelnen Glieder nach der Formel

$$(4) \quad T_N = P * \frac{A^{(N-1)}}{A^{(N-1)} + 1}$$

und
bei negativem Vorzeichen der einzelnen Glieder nach der Formel

$$(5) \quad T_N = P * \frac{A^{(N-1)}}{A^{(N-1)} - 1}$$

erfolgt.

8. Längen- oder Winkelmeßeinrichtung mit einer Maßverkörperung die mehrere Meßteilungen mit unterschiedlichen Teilungsperioden aufweist, denen jeweils Abtasteinrichtungen zugeordnet sind, und bei der die von den Abtasteinrichtungen erzeugten Signale mit an sich bekannten Verfahren unterteilt werden, wobei durch einen Unterteilungsfaktor die Anzahl der Interpolationsschritte einer Meßteilung bestimmt werden, dadurch gekennzeichnet, daß für die Grundteilung (4) die Anzahl B der Interpolationsschritte gleich einer Anzahl B von Codewerten ist, und daß für die weiteren Meßteilungen (5, 6, 7) aus B Interpolationsschritten eine Anzahl A von Codewerten gebildet wird, wobei A≦B/2 ist.

9. Längen- oder Winkelmeßeinrichtung nach Anspruch 8, dadurch gekennzeichnet, daß eine weitere Meßteilung als Referenzspur (0) vorgesehen ist, deren Teilungsperiode $P_0$ kleiner ist als die Teilungsperiode P der Grundteilung (4; 44), und daß die Phasenlage der N Meßteilungen (4, 5, 6, 7; 44, 54, 64, 74) auf diese Referenzspur (0) bezogen ist.

10. Längen- oder Winkelmeßeinrichtung nach Anspruch 9, dadurch gekennzeichnet, daß die Referenzspur (0) die Teilungsperiode

$$P_0 = \frac{1}{A} \cdot P$$

aufweist.

11. Längen- oder Winkelmeßeinrichtung nach einem der Ansprüche 1, 2 oder 8, dadurch gekennzeichnet, daß die Längen- oder Winkelmeßeinrichtung wahlweise als absolute Positionsmeßeinrichtung oder als inkrementale Wegmeßeinrichtung betreibbar ist.

**Claims**

1. A length or angle measuring device with a measuring unit which has a plurality of measuring scales with different scale periods and with which respective sensing devices are associated, characterized in that a first measuring scale (4) has a scale period ($T_1$) with the value P and the reciprocals of the scale periods ($T_N$) of the further measuring scales (5, 6, 7) less the reciprocal value 1/P of the scale period ($T_1$) of the first measuring scale (4) form a finite geometrical progression summed up to the (n-1)th member for the Nth measuring scale ($T_N$).

2. A length or angle measuring device with a measuring unit which has a plurality of measuring scales with different scale periods and with which respective sensing devices are associated, characterized in that a first measuring scale (4) has a scale period ($T_1$) with the value P and the reciprocals of the scale periods ($T_N$) of the further measuring scales (5, 6, 7) less the reciprocal value 1/P of the scale period ($T_1$) of the first measuring scale (4) are stepped in accordance with a geometrical progression.

3. A length or angle measuring device according to claim 1 or 2, characterized in that the stepping of the scale periods ($T_N$) runs continuously.

4. A length or angle measuring device according to claim 1 or 2, characterized in that the stepping of the scale periods ($T_N$) is effected in blocks (C, K∗C) of different lengths with respective like scale period P + B/A and in that the blocks (C, K∗C) have a phase shift (D or E) relative to one another.

5. A length or angle measuring device according to claim 4, characterized in that the phase shift (D or E) is different in the tracks of the measuring scales (63, 73).

6. A length or angle measuring device according to claim 1, characterized in that the stepping of the measuring scales (4, 5, 6, 7; 42, 52, 62, 72; 43, 53, 63, 73) is effected with a positive sign of the individual elements according to formula (1)

$$(1) \quad T_N = P * \frac{A^{(N-1)}}{\sum_{i=0}^{N-1}(A^i)}$$

and with a negative sign of the individual elements according to the formula

$$(2) \quad T_N = P * \frac{A^{(N-1)}}{A^{(N-1)} - \sum_{i=0}^{N-2}(A^i)}$$

7. A length or angle measuring device according to claim 2, characterized in that the stepping of the measuring scales with a positive sign of the individual elements is effected according to the formula

$$(4) \qquad T_N = P * \frac{A^{(N-1)}}{A^{(N-1)} + 1}$$

and with a negative sign of the individual elements according to the formula

$$(5) \qquad T_N = P * \frac{A^{(N-1)}}{A^{(N-1)} - 1}$$

8. A length or angle measuring device with a measuring unit which has a plurality of measuring scales with different scale periods and with which respective sensing devices are associated, and in which the signals generated by the sensing devices are subdivided by methods known per se, wherein the number of interpolation steps of a measuring scale are determined by a sub-division factor, characterized in that the number B of interpolation steps for the base scale (4) is equal to a number B of code values and in that a number A of code values is formed for the further measuring scales (5, 6, 7) from B interpolation steps, where $A \leqq B/2$.

9. A length or angle measuring device according to claim 8, characterized in that a further measuring scale is provided as a reference track (0) with its scale period $P_0$ smaller than the scale period P of the base scale (4; 44), and in that the phase position of the N measuring scales (4, 5, 6, 7; 44, 54, 64, 74) is related to this reference track (0).

10. A length or angle measuring device according to claim 9, characterized in that the reference track (0) has the scale period $P_0 = (1/A) \cdot P$.

11. A length or angle measuring device according to any of claims 1, 2 and 8, characterized in that the length or angle measuring device can be operated selectively as an absolute position measuring device or as an incremental displacement measuring device.

## Revendications

1. Dispositif de mesure de longueurs ou d'angles comportant une matérialisation de la mesure qui présente plusieurs graduations de mesure avec des périodes de graduation différentes auxquelles sont associées chaque fois des dispositifs de lecture, caractérisé par le fait qu'une première graduation de mesure (4) présente une période de graduation ($T_1$) de valeur P et que les valeurs inverses des périodes de graduation ($T_N$) des autres graduations de mesure (5, 6, 7) moins la valeur inverse 1/P de la période de graduation ($T_1$) de la première graduation de mesure (4) représentent une série géométrique finie jusqu'au (n - 1)ième terme pour la N ième graduation de mesure ($T_N$).

2. Dispositif de mesure de longueurs ou d'angles comportant une matérialisation de la mesure qui présente plusieurs graduations de mesure avec des périodes de graduation différentes auxquelles sont associées chaque fois des dispositifs de lecture, caractérisé par le fait qu'une première graduation de mesure (4) présente une période de graduation ($T_1$) de valeur P et que les valeurs inverses des périodes de graduation ($T_N$) des autres graduations de mesure (5, 6, 7) moins la valeur inverse 1/P de la période de graduation ($T_1$) de la première graduation de mesure (4) sont échelonnées suivant une progression géométrique.

3. Dispositif de mesure de longueurs ou d'angles selon la rvendication 1 ou la revendication 2, caractérisé par le fait que l'échelonnement des périodes de graduation ($T_N$) est continu.

4. Dispositif de mesure de longueurs ou d'angles selon la revendication 1 ou la revendication 2, caractérisé par le fait que l'échelonnement des périodes de graduation ($T_N$) est obtenu au moyen de blocs (C, K$*$C) de longueur différente, avec chaque fois la même période de graduation P+B/A, et par le fait que les blocs (C, K$*$C) présentent un déphasage mutuel (D ou E).

5. Dispositif de mesure de longueurs ou d'angles selon la revendication 4, caractérisé par le fait que le déphasage mutuel (D ou E) dans les pistes des graduations (63, 73) varie.

6. Dispositif de mesure de longueurs ou d'angles selon la revendication 1, caractérisé par le fait que l'échelonnement des graduations de mesure (4, 5, 6, 7; 42, 52, 62, 72; 43, 53, 63, 73), pour un signe positif des différents termes, répond à la formule

$$(1) \quad T_N = P * \frac{A^{(N-1)}}{\sum\limits_{i=0}^{N-1}(A^i)}$$

et, pour un signe négatif des différents termes, à la formule

$$(2) \quad T_N = P * \frac{A^{(N-1)}}{A^{(N-1)} - \sum\limits_{i=0}^{N-2}(A^i)}$$

7. Dispositif de mesure de longueurs ou d'angles selon la revendication 2, caractérisé par le fait que l'échelonnement des graduations de mesure, pour un signe positif des différents termes, répond à la formule

$$(4) \quad T_N = P * \frac{A^{(N-1)}}{A^{(N1)} + 1}$$

et, pour un signe négatif des différents termes, à la formule

$$(5) \quad T_N = P * \frac{A^{(N-1)}}{A^{(N-1)} - 1}$$

8.  Dispositif de mesure de longueurs ou d'angles comportant une matérialisation de la mesure qui présente plusieurs graduations de mesure avec des périodes de graduation différentes, auxquelles sont associées chaque fois des dispositifs de lecture, et dans lequel les signaux produits par les dispositifs de lecture sont subdivisés par un procédé connu en soi, le nombre de pas d'interpolation d'une graduation de mesure étant déterminé par un facteur de division, caractérisé par le fait que pour la graduation de base (4) le nombre B de pas d'interpolation est égal à un nombre B de valeurs de code et par le fait que pour les autres graduations de mesure (5, 6, 7) on forme à partir de B pas d'interpolation un nombre A de valeurs de code, $A \leqq B/2$.

9.  Dispositif de mesure de longueurs ou d'angles selon la revendication 8, caractérisé par le fait qu'il est prévu comme piste de référence (0) une piste supplémentair, dont la période de graduation $P_0$ est inférieure à la période P de la graduation de base (4; 44) et par le fait que le phasage des N graduations de mesure (4, 5, 6, 7; 44, 54, 64, 74) est rapporté à cette piste de référence (0).

10. Dispositif de mesure de longueurs ou d'angles selon la revendication 9, caractérisé par le fait que la piste de référence (0) présente la période de graduation $P_0 = 1/A * P$.

11. Dispositif de mesure de longueurs ou d'angles selon l'une des revendications 1, 2 ou 8, caractérisé par le fait que le dispositif de mesure de longueurs ou d'angles peut être utilisé au choix comme dispositif de mesure absolu ou comme dispositif incrémental de mesure de déplacement.

Fig. 1

EP 0 526 730 B1

Fig. 2

Fig. 3

EP 0 526 730 B1

Fig. 4

EP 0 526 730 B1